## Europäisches Patentamt
## European Patent Office
## Office européen des brevets

(11) Veröffentlichungsnummer: **0 104 393**
**B1**

(12) **EUROPÄISCHE PATENTSCHRIFT**

(45) Veröffentlichungstag der Patentschrift: **11.07.90**

(21) Anmeldenummer: **83108015.5**

(22) Anmeldetag: **12.08.83**

(51) Int. Cl.⁵: **G 01 D 5/245, H 03 M 1/22**

(54) Auswerteeinrichtung für einen digitalen Inkrementalgeber.

(30) Priorität: **27.08.82 DE 3231990**

(43) Veröffentlichungstag der Anmeldung:
**04.04.84 Patentblatt 84/14**

(45) Bekanntmachung des Hinweises auf die
Patenterteilung:
**11.07.90 Patentblatt 90/28**

(84) Benannte Vertragsstaaten:
**CH DE FR GB IT LI SE**

(56) Entgegenhaltungen:
**US-A-3 675 238**
**US-A-4 346 447**

(73) Patentinhaber: **Siemens Aktiengesellschaft**
**Wittelsbacherplatz 2**
**D-8000 München 2 (DE)**

(72) Erfinder: **Papiernik, Wolfgang, Dr.**
**Eskilstunastrasse 9**
**D-8520 Erlangen (DE)**

Courier Press, Leamington Spa, England.

EP 0 104 393 B1

**Beschreibung**

Die Erfindung bezieht sich auf ein Wegmeßverfahren nach dem Oberbegriff des Hauptanspruches und auf eine entsprechende Schaltungsanordnung.

Inkrementalgeber zur Weg- bzw. Winkelerfassung können als lineare oder rotierende Systeme ausgeführt sein und z.B. auf fotoelektrischer oder magnetischer Basis arbeiten. Gemeinsam ist allen diesen Systemen, daß die Nulldurchgänge oder Verknüpfungen der Sinusspannungen ausgewertet und zur Abbildung des Weges herangezogen werden. Ein digitaler Geber auf magnetischer Basis ist beispielsweise in der Siemens-Zeitschrift 1960, Seiten 669 bis 671 beschrieben, auf optischer Basis z.B. in der Zeitschrift Siemens Components, 1981, Heft 1, Seiten 12 bis 13.

Ein Wegmeßverfahren der eingangs genannten Art, das prinzipiell von solchen Gebersystemen Gebrauch macht, ist aus der US—PS 36 75 238 bekannt. Das Generieren der Wegmeßwerte aus den Gebersignalen er folgt dabei jedoch über eine Vielzahl von Verfahrensschritten. Ferner sei noch auf die US—PS 43 46 447 verwiesen, die bei einer genannten Stand der Technik verwandten Schaltung den Einsatz von adressierbaren Festwertspeichern beschreibt.

Aufgabe der Erfindung ist es, im Verfahren der eingangs genannten Art so auszubilden, daß es in technisch möglichst einfacher Art realisiert werden kann.

Diese Aufgabe wird erfindungsgemäß durch die kennzeichnenden Merkmale des Hauptanspruches gelöst, Vorteilhafte Ausgestaltungen der Erfindung sind in den abhängigen Patentansprüchen beschrieben. Eine entsprechende Schaltung ergibt sich aus dem Anspruch 5.

Anhand eines in der Zeichnung dargestellten Ausführungsbeispiels sei die Erfindung näher erläutert; es zeigen:

Figur 1 ein Prinzipschaltbild der Auswerteeinrichtung,

Figur 2 die Sinusausgangsspannungen an den Ausgängen des Inkrementalgebers,

Figur 3 aus den Sinusspannungen abgeleitete Rechteckspannungen,

Figur 4 im vergrößerten Maßstab eine aus den Sinusspannungen abgeleitete Dreieckspannung, die in Figur 3 gezeigten Rechteckspannungen und die aus der Dreieckspannung abgeleiteten Digitalwerte und

Figuren 5 und 6 Regelungs- und Überwachungseinrichtungen.

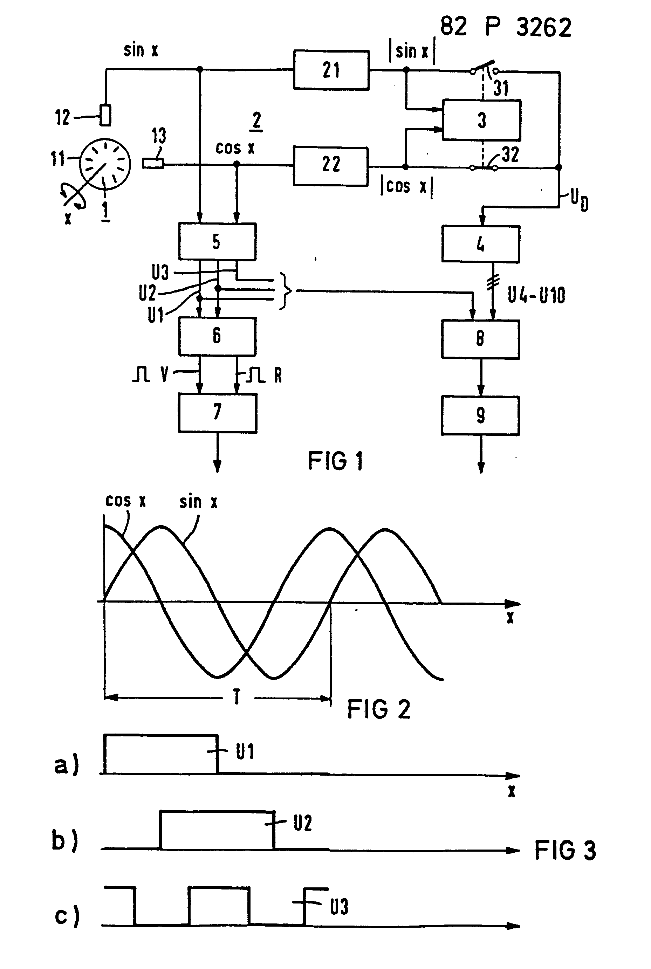

Ein bekannter optischer Inkrementalgeber 1 besteht aus einer Impulsscheibe 11 und zugehörigen Abtasteinrichtungen 12 und 13. An den Ausgängen dieser Abtasteinrichtungen 12 und 13 sind entsprechend der Bewegung x mit sin x und cos x bezeichnete Spannungen (vgl. Figur 2) abnehmbar. Diese Geberrohsignale, die um 90° elektrisch gegeneinander phasenverschoben sind, sind annähernd sinusförmig. Sie haben im Bereich ihres Nulldurchganges (von ca. −45° bis ca. +45°) einen praktisch linear ansteigenden Verlauf; einmal durch die Eigenschaft der Sinusfunktion und zum anderen durch die Gestaltung des Gebers selbst, vor allem bei optischen Gebern. Abweichungen zwischen dem Sinus und einer Geraden lassen sich gegebenenfalls auch durch ein nichtlineares Übertragungsglied berücksichtigen.

Aus den beiden um 90° elektrisch versetzten Spannungen sin x und cos x werden in einer Kippstufenschaltung 5 zwei entsprechend um 90° elektrisch versetzte Rechteckspannungen U1 und U2 erzeugt (vgl. Zeilen a und b in Figur 3). Zusätzlich wird auch noch eine periodische Rechteckspannung U3 doppelter Frequenz erzeugt, deren Flanken jeweils zwischen die Flanken der beiden vorgenannten Spannungen U1 und U2 fallen.

Aus den Rechteckspannungen U1 und U2 werden in an sich bekannter Weise (vgl. die eingangs genannten Literaturstellen) in einer Logik 6 Vorwärts- und Rückwärtszählimpulse erzeugt, die auf einen Zähler 7 gelangen. Der jeweilige Stend dieses Zählers ist dann repräsentativ für den durch Zählung von Perioden T zurückgelegten Weg.

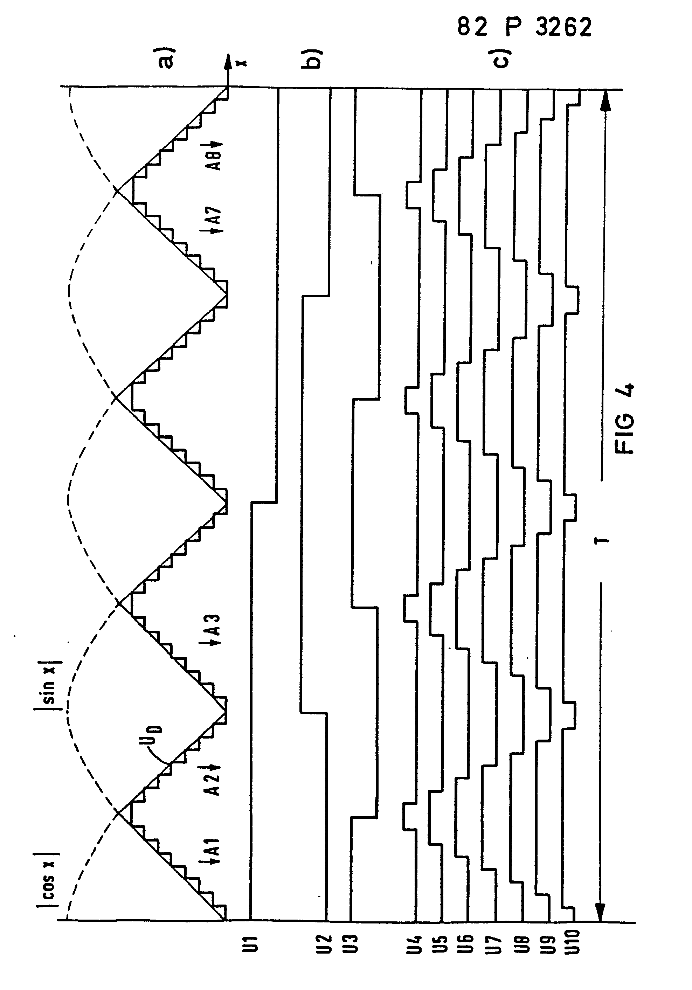

Zusätzlich wird noch aus den beiden um 90° elektrisch versetzten Geberspannungen sin x und cos x ein Dreiecksignal erzeugt, dessen Steigung proportional zu seiner Frequenz ist. Dies geschieht auf einfache Weise dadurch, daß die Absolutbeträge der beiden Spannungen |sin x| und |cos x| gebildet werden (vgl. gestrichet gezeichnelt Kurven in Figur 4, Zeile a) und jeweils der kleinere der beiden Spannungswerte verwendet wird. Hierdurch ergibt sich die gezeichnete Dreieckspannung $U_D$ mit den einzelnen Ästen A1 bis A8 innerhalb einer Periode T des Drehwinkels x.

Zur Bildung dieser Dreieckspannung $U_D$ sind schaltungsmäßig (vgl. Figur 1) in einer Betragsbildneranordnung 2 zwei Betragsbildner 21 und 22 vorgesehen, die an ihren Ausgängen die Spannungen sin x und cos x als Absolutwerte |sin x| und |cos x| zur Verfügung stellen. Diese beiden Spannungen |sin x| und |cos x| werden in einem Spannungsdiskriminator 3 miteinander verglichen und jeweils nur die kleinere der beiden Spannungen ausgewertet. Im vorliegenden Ausführungsbeispiel ist es dadurch angedeutet, daß die Ausgänge der Betragsbildner 21 und 22 wahlweise über vom Spannungsdiskriminator 3 gesteuerte Schalter 31 bzw. 32 geführt sind. Die so entstandene Dreieckspannung $U_D$ wird dann einem Analog-Digitalumsetzer 4 zugeführt, der als Momentanwertverschlüssler mit Komparatoren arbeitet, d.h. aus der vorliegenden Dreieckspannung einen entsprechenden Digitalwert bildet. Auf diese Weise ist jeder der Treppenstufen innerhalb eines Astes A1 bis A8 (vgl. Figur 4, Zeile a) ein eindeutiger Digitalwert zugeordnet. Dieser Digitalwert kann beispielsweise durch die jeweils dieser Treppenstufe zugeordneten Schaltzustände der einzelnen Komparatoren im Analog-Digitalumsetzer in Form der in Figur 4, Zeile c dargestellten Spannungen U4 bis U10 (logische Ausgangssignale) festgelegt sein.

Durch die Rechteckspannungen U1 bis U3 (Figur 4b) an den Ausgängen der Kippstufenlogik 5 ist eindeutig der Ast festgelegt, in dem sich gerade der Weg-Istwert befindet und durch die Zustandskombination der Spannungen U4 bis U10 — d.h. dem betreffenden Digitalwert — jeweils genau die Stelle des Weg-Istwertes innerhalb des Astes. Die jeweiligen Zustandskombinationen der Spannungen U1 und U10 werden daher als Adressen eines Festwertspeichers 8 verwendet, in dem z.B. vierundsechzig äquidistante Positionen innerhalb der Period T gespeichert sind. Wird jeder der 64 möglichen Adressen eindeutig eine dieser Positionen zugeordnet, und zwar in Form eines Absolutwertes, so ist am Ausgang des Festwertspeichers 8 unter der betreffenden Adresse der innerhalb der Periode gerade vorliegende Weg-Istwert abnehmbar und in einen Speicher 9 übertragbar. Das Wegmeßsystem arbeitet also innerhalb der Perioden zyklisch absolut. Der Periodenzählwert im Grobzähler 7 und der Positionswert innerhalb der Periode im Speicher 9 können dann bei Bedarf durch einen Rechner oder dergleichen in vorgegebenen Zeitabständen abgerufen werden.

Die vorstehend erwähnte Auswerteeinrichtung läßt sich auch zur Messung der Drehzahl bzw. Geschwindigkeit verwenden, und zwar in der Weise, daß die Änderung des Weg-Istwertes innerhalb der Periode innerhalb definierter Abtastzeiträume festgestellt wird und als Maß für die Geschwindigkeit dient.

Es sei ferner noch bemerkt, daß es gelegentlich auch von Vorteil sein kann, wenn bereits vorhandene Steuerungselemente verwendet werden sollen, daß aus den Spannungen U1 bis U10 neue Impulsfolgen abgeleitet werden, wie es an sich bereits bei der Auswertung der beiden Rechteckspannungen U1 und U2 zur Bildung von Zählimpulsen bekannt ist. Durch die Vielzahl von weiteren periodischen Rechteckspannungen U3 bis U10 ist jedoch die Frequenz dieser abgeleiteten Pulsfolgen erheblich erhöhbar, z.B. verzwanzigfachbar.

Das Dreiecksignal läßt sich bei optischen Gebern auch zur Regelung des Lichtstromes benutzen, z.B. in der Weise, daß an den Maxima der Dreieckspannung, die durch die zugehörigen Adressen eindeutig definiert sind, gefragt wird, ob das Maximum einen vorgegebenen Referenzwert erreicht oder nicht und abhängig davon der Lampenstrom im Geber geändert wird.

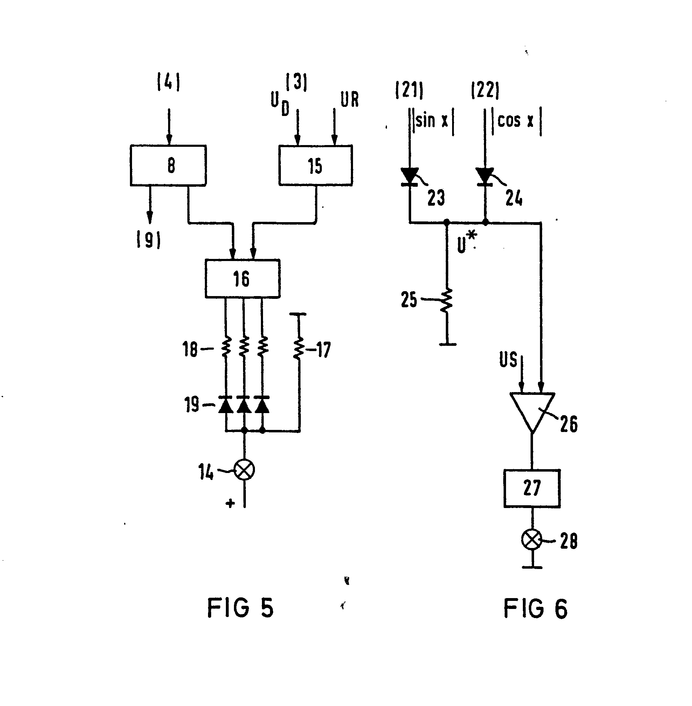

Schaltungsmäßig läßt sich dies verhältnismäßig einfach dadurch realisieren — vgl. Figur 5 —, daß durch den Festwertspeicher 8 an den definierten Stellen ein Impuls zu einem Zähler 16 gelängt, der je nachdem, ob der gerade vorliegende Maximalwert der Dreieckspannung $U_D$ größer oder kleiner als eine Referenzspannung $U_R$ ist, was durch einen Komparator 15 festgestellt wird — vorwärts oder rückwärts zählt. An die Ausgänges des Zählers 16 sind gewichtete Widerstände 18 angeschlossen und je nach Zählstand an Masse gelegt. Hierdurch wurden in den Stromkreis der Lampe 14 mehr oder weniger Widerstände 18 über Dioden parallel zum Grundwiderstand 17 geschaltet und damit der Lampenstrom entsprechend verändert.

Die Absolutbeträge der Sinusspannungen, die zur Erzeugung des Dreiecksignals dienen, können auch zur Überwachung von Amplituden oder Phasenstörungen benutzt werden. Hierzu wird aus den Absolutwerten $|\sin x|$ und $|\cos x|$ jeweils mittels Dioden 23, 24 der jeweils größte Wert ausgewählt und liegt als Spannung $U^*$ am Widerstand 25. Diese Spannung $U^*$ wird mit einem Referenzwert $U_S$ verglichen. Sinkt die aus den Absolutwerten zusammengesetzte Spannung unter diesen Referenzwert $U_S$, so spricht die Kippstufe 27 an und eine Störungsanzeige 28 leuchtet auf.

**Patentansprüche**

1. Wegmeßverfahren, bei dem aus zwei um 90° elektrisch phasenverschobenen weg- bzw. winkelabhängigen Sinusspannungen gleicher Amplitude und Periode eine periodische Dreieckspannung erzeugt wird, die in Digitalwerte umgesetzt wird, dadurch gekennzeichnet, daß

a) die Absolutbeträge ($|\sin x|$, $|\cos x|$) beider Spannungen gebildet werden,

b) jeweils die kleinere der beiden Spannungen ausgewählt wird,

c) die so erhaltene Dreiecksspannung ($U_D$) in entsprechende Digitalwerte umgesetzt wird, und

d) diese Digitalwerte in Verbindung mit aus den Sinusspannungen abgeleiteten logischen Signalen ($U_1$ bis $U_3$) zur Adressierung eines Festwertspeichers (8) dienen, im dem die entsprechenden Absolutwerte innerhalb einer Periode (T) gespeichert sind.

2. Wegmeßverfahren nach Anspruch 1, dadurch gekennzeichnet, daß die Änderung des Digitalwertes und/oder der am Ausgang des Istwertspeichers abnehmbaren Werte als Maß für die Geschwindigkeit bzw. Drehzahl dient.

3. Wegmeßverfahren nach Anspruch 1 oder 2 zur Verwendung bei optischen Inkrementalgebern mit einer das Licht erzeugenden Lampe, dadurch gekennzeichnet, daß an den Maxima der Dreieckspannung ($U_D$) der Wert dieser Spannung mit einem Referenzwert ($U_R$) verglichen wird und abhängig vom Vergleich der Lampenstrom änderbar ist.

4. Wegmeßverfahren nach Anspruch 1, 2 oder 3, dadurch gekennzeichnet, daß aus den Absolutbeträgen beider Sinusspannungen (sin x, cos x) der jeweils größere Spannungswert ausgewählt wird und daß ein Störsignal ausgegeben wird, wenn die so erhaltene Spannung ($U^*$) einen Referenzwert ($U_S$) unterschreitet.

5. Schaltungsanordnung zur Durchführung des Verfahrens nach einem der vorstehenden Ansprüche, gekennzeichnet durch an die Geberausgänge angeschlossene Betragsbildner (21, 22) mit zugeordnetem Spannungsdiskriminator (3) und einem nachgeschalteten Analog-Digitalumsetzer (4) mit von ihm adressierten Festwertspeicher (8).

**Revendications**

1. Procédé de mesure de déplacements, selon lequel à partir de deux tensions sinusoïdales qui présentent entre elles un déphasage électrique de 90°, qui dépendent d'une distance et d'un angle et qui possèdent une même amplitude et une même période, on forme une tension triangulaire périodique, qui est convertie en valeurs numériques, caractérisé par le fait que

a) on forme les valeurs absolues ($|\sin x|$, $|\cos x|$) des deux tensions,

b) on sélectionne respectivement la plus petite des deux tensions,

c) on convertit la tension triangulaire ($U_D$) ainsi obtenue en des valeurs numériques correspondantes, et

d) on utilise ces valeurs numériques, en liaison avec des signaux logiques ($U_1$ à $U_3$), dérivés des tensions sinusoïdales, pour adresser une mémoire fixe (8), dans laquelle les valeurs absolues correspondantes sont mémorisées pendant une période (T).

2. Procédé de mesure de déplacement suivant la revendication 1, caractérisé par le fait que la modification de la valeur numérique et/ou des valeurs pouvant être prélevées à la sortie de la mémoire de valeurs réelles est utilisée comme mesure de la vitesse ou de la vitesse de rotation.

3. Procédé de mesure de déplacement suivant la revendication 1 ou 2, pour son utilisation dans des capteurs optiques incrémentaux comportant une lampe produisant la lumière, caractérisé par le fait qu'au niveau des maxima de la tension triangulaire ($U_D$), la valeur de cette tension est comparée à une tension de référence ($U_R$) et le courant de la lampe peut être modifié en fonction de la comparaison.

4. Procédé de mesure de déplacément suivant la revendication 1, 2 ou 3, caractérisé par le fait que parmi les valeurs absolues des deux tensions sinusoïdales ($\sin x$, $\cos x$), la valeur de tension respectivement la plus élevée est sélectionnée et qu'un signal parasite est délivré lorsque la tension ($U^*$) ainsi obtenue tombe au-dessous d'une valeur de référence ($U_S$).

5. Montage pour la mise en oeuvre du procédé suivant l'une des revendications précédentes, caractérisé par des dispositifs (21, 22) de formation de valeurs absolues, qui sont raccordés aux sorties du capteur, par un discriminateur de tension (3) associé à ces dispositifs, par un convertisseur analogique/numérique (4) branché en aval, et par une mémoire morte (8) adressée par ce convertisseur.

**Claims**

1. Position measuring method in which a periodic delta voltage is produced from two position-dependent or angle-dependent sinusoidal voltages which are shifted in phase by 90% and are of the same amplitude and period, which delta voltage is converted into digital values, characterised in that:

a) the absolute values ($|\sin x|$, $|\cos x|$) are formed of the two voltages.

b) the lower of the two voltages is selected in each case;

c) the delta voltage ($U_D$) obtained thus is converted into corresponding digital values, and

d) these digital values serve, in conjunction with logic signals ($U_1$ to $U_3$) discharged from the sinusoidal voltages, for addressing a read-only memory (8) in which the corresponding absolute values are stored within a period (T).

2. Position measuring method according to claim 1, characterised in that the change in the digital value, and/or the value which can be taken at the output of the actual-value memory, serves as the measurement of the speed or rotational speed.

3. Position measuring method according to claim 1 or 2, for use with optical incremental transmitters having a lamp which produces light, characterised in that, at the delta voltage ($U_D$) peaks, the value of this voltage is compared with a reference value ($U_R$), and the current flowing through the lamp can be changed in dependence upon the comparison.

4. Position measuring method according to claim 1, 2 or 3, characterised in that the higher voltage value is selected in each case from the absolute values of the two sinusoidal voltages ($\sin x$, $\cos x$), and in that an interference signal is transmitted when the voltage ($U^*$) thus obtained falls below a reference value ($U_S$).

5. Circuit arrangement for carrying out the method according to one of the preceding claims, characterised by absolute-value generators (21, 22) which are attached to the transmitter outputs and have an associated voltage discriminator (3) and an analog-to-digital converter (4) connected downstream with a read-only memory (8) addressed by it.

82 P 3262

FIG 1

FIG 2

FIG 3

FIG 4

EP 0 104 393 B1

82 P 3262

FIG 5

FIG 6